Europäisches Patentamt

(19) European Patent Office

Office européen des brevets

(11) EP 0 753 888 A2

(12) EUROPEAN PATENT APPLICATION

(43) Date of publication:
15.01.1997 Bulletin 1997/03

(51) Int. Cl.$^6$: H01L 21/56, B29C 33/68, B29C 70/72

(21) Application number: 96201767.9

(22) Date of filing: 25.06.1996

(84) Designated Contracting States:
AT BE CH DE ES FR GB IE IT LI LU PT SE

(30) Priority: 11.07.1995 NL 1000777

(71) Applicant: " 3P" LICENSING B.V.
NL-6902 PA Zevenaar (NL)

(72) Inventors:
• Pas, Ireneus Johannes Theodorus Maria
6891 AG Rozendaal (NL)
• Vos, Eltjo
7523 CH Enschede (NL)

(74) Representative: Timmers, Cornelis Herman
Johannes
van Exter Polak & Charlouis B.V.,
P.O. Box 3241
2280 GE Rijswijk (NL)

(54) Method for encapsulating an electronic component and article obtained thereby

(57) Method for encapsulating, in a mould (48a,48b), an electronic component (30) having a number of laterally projecting elongated connecting elements (33) situated next to one another in one plane, said connecting elements being without metallic through connection and having a certain mutual pitch ($P_L$), width ($W_L$) and height ($T_L$), and with the insertion of two films (8a,8b), each having a predetermined thickness ($T_{FT}$ and $T_{FB}$, respectively), a deformable film being used and the encapsulation being carried out under conditions which are such that, during the process, the condition

$$C \cdot T_L - \left\{ 1 - \frac{W_L}{P_L} \right\} \leq (T_{TF} + T_{BF})$$

at the position of the clamping edges of the matrix parts, while

$$C \geq 2.5.$$

Fig. 5a

Fig. 5b

## Description

The invention relates to a method as described in the preamble of claim 1, to an electronic component as described in the preamble of claim 4 and to an encapsulated component obtained using the method according to the invention.

The encapsulation of an electronic component making use of two films enclosing the component during the encapsulation has been described in the non-pre-published Dutch Patent Application 9400119 in the name of the Applicant, filed on 27 January 1994 corresponding to EP-A-0665584.

Said method is carried out on an electronic component with a so-called "dambar" between the connecting elements (the so-called leads which together form the lead frame): said "dambar" is a metallic connection of the connecting element ends matching the external circumference of the mould cavity. Said "dambar" must be present since, although a seal is obtained between the connecting elements and the two mould-cavity edges during the clamping of the connecting element ends between the edges of the mould cavities, such a seal is not present between the respective ends themselves; without the "dambar" an opening, through which the injected encapsulating material can escape, will always remain present between two adjacent connecting elements.

Of course the dambar has to be removed after the encapsulation, for which purpose the material thereof between the respective adjacent connecting elements is removed by, for example, a suitable punching operation. This additional removing step requires a complicated punching tool matched to the lead frame, requires time, and increases the manufacturing costs. Hitherto, however, said additional removing step was indispensable.

The invention is based on the insight that, if certain conditions are fulfilled in carrying out the method, the film will be able to fill up the spaces between the connecting elements when the mould is being closed, as a result of which the dambar becomes superfluous.

Said conditions are defined in the characterizing clause of the main claim.

As a result of the omission of the dambar, not only is the necessary additional removing step unnecessary, but the designer of the electronic component and the "leadframe" used in the process acquires a much greater freedom: after all, it is no longer necessary to take account of an additional operation of punching the lead frame subsequently.

Preferably, the method is carried out in the manner defined in claims 2 and 3.

The exclusive claimed rights cover moreover an electronic component according to the preamble of claim 4, which is constructed in the manner defined in the characterizing clause of claims 4 and 5, respectively, and also to an encapsulated component obtained using the method according to the invention.

It is observed that the French patent specification 2103917 describes a method for encapsulating electronic components in which the components with their lead frame are, prior to their placing in the mould placed between two foils which are either provided with openings through which the components protrude or with cavities with perforated walls which enclose the components. Thereafter the encapsulating material is injected.

This method thus needs a time consuming extra step in preparing the components which increases the fabricating costs. Furthermore no details are given as to the thickness of the foil in relation to the dimensions of the leadframe.

The US patent specification 5106784 describes an encapsulating method using an elastic tape placed over the lead frame and intended to fill the space between the individual leads when the mould is closed.

The French patent specification 2051332 describes an encapsulating method according to which the space between the leads is filled with elastic material; a similar method is disclosed in the US patent specification 518271 and in the European patent application 0 478 467.

According to the US patent specification 4504427 the space between the leads is filled with a material different from the leads and to be removed after the encapsulating step.

Contrary to the method according to the invention all these known methods need an extra step for preparing the component with its lead frame prior to the encapsulating step.

The invention is explained by reference to the drawing. In the drawing:

Figures 1a - 1d show diagrammatically the steps of encapsulating a semiconductor component as carried out using the method which is the subject of Dutch Patent Application 9400119 in the name of the Applicant;

Figure 2 is a plan view of a design of connecting elements (lead frame) according to the prior art;

Figure 3 is a corresponding plan view of such a lead frame, in which the measures according to the invention have been used;

Figure 4 is a plan view of three connecting elements (leads) at the position of the widened portions thereof;

Figure 5a is a cross section of said leads prior to the enclosure thereof between the two films; and

Figure 5b is a cross section through said leads after the enclosure between the films.

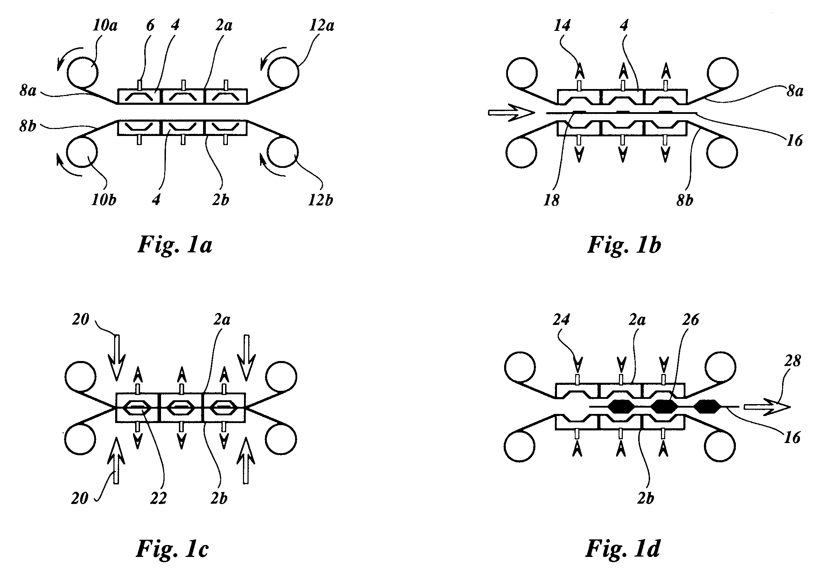

Figure 1a shows diagrammatically two mould halves 2a, 2b with the mould cavities 4 therein. The conventional openings for evacuating the mould cavities are denoted by 6; 8a denotes a top film which is wound in steps from a stock roller 10a to a take-up roller 12a, and 8b denotes a bottom film which is wound in steps from a stock roller 10b to a take-up roller 12b.

Figure 1b shows how the top film and bottom film have come to rest against the walls of the mould cavities 4 after the evacuation via the opening 6, denoted diagrammatically by the arrows 14; a carrier 16 with a number of electronic components 18, for example ICs, to be encapsulated is placed in the mould.

Figure 1c shows the situation in which the two mould halves 2a, 2b have been moved towards each other in the direction of the arrows 20 and encapsulating material is injected into the spaces 22 of the mould cavities (not shown), which is now closed. After the curing of the material, the two mould halves 2a, 2b are moved away from each other, as shown in Figure 1d, the film is released from the walls of the mould cavity by supplying pressurized medium via the openings 24 and the encapsulated components 26 are removed in the direction of the arrow 28.

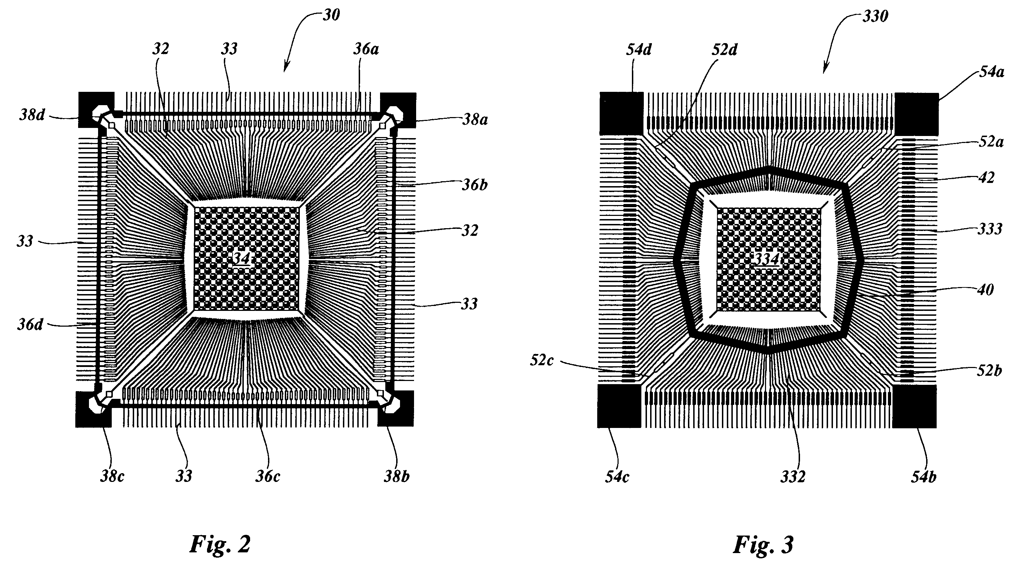

Figure 2 shows a plan view of a "lead frame" according to the prior art, denoted in its entirety by the reference numeral 30. It comprises a large number of individual connecting elements, the so-called leads 32, which are connected to the centrally placed semiconductor component 34. The component 34 and most of the lead frame must be enveloped during the encapsulation; only the four rows of end parts 33 of the leads then still project outside the envelope after this operation.

In the closed mould cavity, said end parts 33 are securely clamped between the respective edges thereof. Since a gap is always present between the individual leads, the encapsulating material injected under pressure will escape through the latter, as already explained, if no additional measures are taken. To prevent this, the prior art provides for the so-called "dambar" which is in fact a continuous local metallization between the lead ends 33. Said dambar comprises the straight parts 36a - 36d and the four parts 38a - 38d which terminate the corners.

Of course, said dambar, which forms an electrical connection of the lead ends 33, has to be removed after the encapsulation and, according to the known prior art, this is done with a suitable punching tool. A separate, very accurately finished punching tool has to be used for every lead frame configuration and the operation requires an accurate positioning thereof with respect to the lead frame; this results in a marked increase in the manufacturing costs.

The measures according to the invention eliminate this drawback.

The invention is based on the insight that, if use is made of a suitable film and a certain dimensioning of the leads, the film material will penetrate into the gaps between the leads during the clamping tight of the mould, it will seal said gaps and, consequently, render the presence of the dambar superfluous.

Figure 3 shows a plan view of a lead frame according to the invention, denoted in its entirety by 330. As is evident, a dambar is no longer present between the ends 333 of the individual leads 332; said ends 333 are widened locally, as denoted by 42; the respective widened sections 42 are situated next to each other in rows.

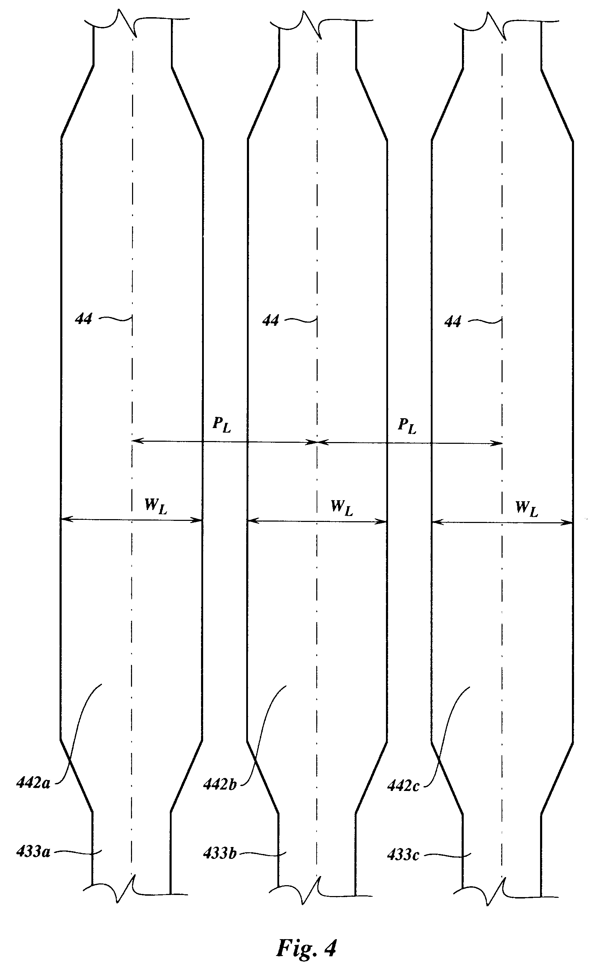

The invention proposes a particular dimensioning of the films used during the encapsulation and of the lead ends which is explained by reference to Figures 4 and 5a.

Figure 4 shows a plan view of three lead ends 433a, 433b, 433c which are situated next to one another and have widened sections 442a, 442b, 442c. The width of each widened section is denoted by $W_L$ and the mutual pitch, that is to say the distance between the respective centre lines 44, by $P_L$. The thickness of the leads is denoted by $T_L$. In Figure 5a, these quantities are also shown with the thickness $T_{TF}$ of the top film 46a and the thickness $T_{BF}$ of the bottom film 46b. The edges 48a, 48b of the two mould cavities are also shown diagrammatically in this figure.

According to the invention, the films 46a, 46b are deformable; a suitable film is, for example, ETFE film. Moreover if care is now taken to ensure that the requirement:

$$C \cdot T_L \cdot \left\{ 1 - \frac{W_L}{P_L} \right\} \leqq (T_{TF} + T_{BF})$$

is met, while

$$C \geqq 2.5$$

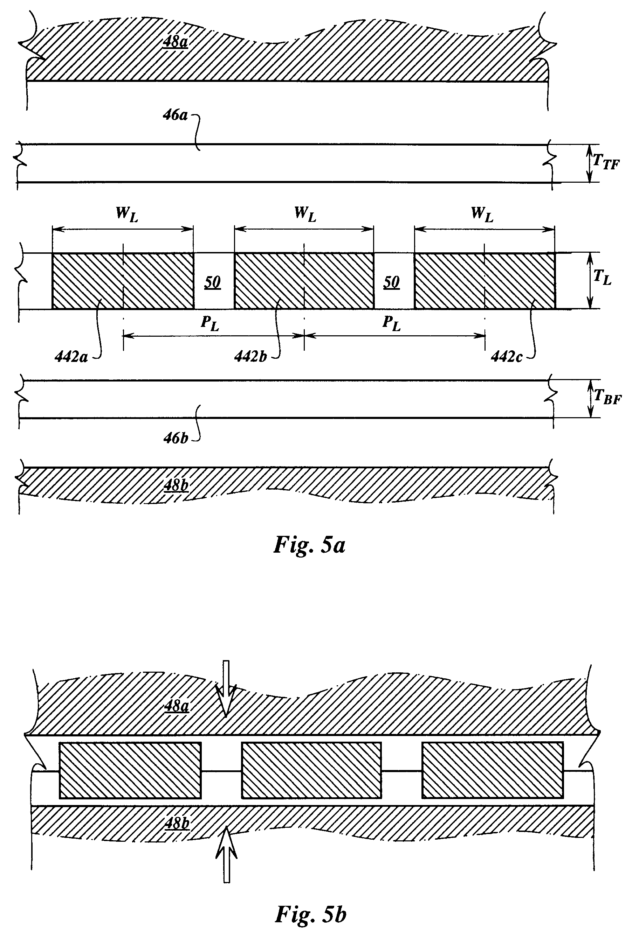

the situation according to Figure 5b is obtained where the edges 48a, 48b are pressed against each other, that is to say in the direction of the arrows shown in Figure 5b: displaced material of the top film 46a or bottom film 46b, respectively, fills the gaps 50 between the leads completely and ensures an effective sealing thereof; the encapsulating material injected during the encapsulation cannot escape via said gaps 50 and the mould cavity remains perfectly sealed.

Preferably, the condition:

$$0.25 \cdot W_L \leqq T_L \leqq 2 \cdot W_L$$

will also be fulfilled and it will be ensured that the ratio of the width ($W_L$) and the pitch ($P_L$) fulfils the requirement

$$0.25 \leqq \frac{W_L}{P_L}$$

It will be clear that the widened sections 42 will be provided if required by the circumstances, in particular by the configuration of the lead frame.

Of course, it is necessary to ensure a sealing at the position of the corners of the lead frame. Figure 3 shows how this can be achieved by providing a metallization 54a - 54d in the corners, at the ends of the respective diagonally extending, so-called tie straps 52a - 52d. The space between the edges of said tie straps and the respective lead ends 333 situated next to them is filled up by displaced film material, as explained above.

In a practical embodiment, the following dimensioning is used:

$T_L$ :       0.15 mm
$W_L$ :      0.38 mm
$P_L$ :       0.50 mm
$T_{TF}$:    0.10 mm
$T_{BF}$:    0.10 mm.

It will be clear that the embodiment described above is given only by way of example and is in no way restrictive.

**Claims**

1. Method for encapsulating an electronic component having a number of laterally projecting elongated connecting elements situated next to one another essentially in one plane and having a certain mutual pitch ($P_L$), width ($W_L$) and height ($T_L$), by making use of a mould comprising two parts which define a mould cavity and two films which enclose the component and at least a portion of the connecting elements projecting therefrom, each film having a predetermined thickness ($T_{FT}$ or $T_{FB}$), respectively, characterized in that the method is carried out on a component in which no metallic through-connection is present between the connecting elements at the component side, a deformable film is used and the encapsulation is carried out under conditions which are such that, during the process, the condition

$$C \cdot T_L - \left\{ 1 - \frac{W_L}{P_L} \right\} \leqq (T_{TF} + T_{BF})$$

is fulfilled at the position of the clamping edges of the mould parts, while

$$C \geqq 2.5.$$

2. Method according to claim 1, characterized in that the method is carried out on a component whose width ($W_L$) of the connecting elements at the position of the clamping edges of the mould parts fulfils the condition

$$0.25 \cdot W_L \leqq T_L \leqq 2 \cdot W_L.$$

3. Method according to claims 1 - 2, characterized in that an ETFE film is used.

4. Electronic component provided with a number of laterally projecting elongated metallic connecting elements situated next to one another essentially in one plane and having a certain mutual pitch ($P_L$), width ($W_L$) and height ($T_L$), suitable to be used for carrying out of the method according to claims 1 - 3, characterized in that no metallic through-connection is present between the connecting elements at the component side and in that the ratio of the width ($W_L$) at the position of the clamping edges of the mould parts and the pitch ($P_L$) fulfils the condition

$$0.25 \leqq \frac{W_L}{P_L}$$

5. Component according to claim 4, characterized in that the connecting elements are widened at the position of the clamping edges of the mould parts.

6. Encapsulated component obtained using the method according to claims 1 - 3.

*Fig. 1b*

*Fig. 1d*

*Fig. 1a*

*Fig. 1c*

5

*Fig. 2*

*Fig. 3*

EP 0 753 888 A2

$44$

$44$

$44$

$P_L$

$P_L$

$W_L$

$W_L$

$W_L$

442a

442b

442c

433a

433b

433c

*Fig. 4*

Fig. 5a

Fig. 5b